# EUROPÄISCHE PATENTSCHRIFT

(11) **EP 0 667 450 B1**
(45) Veröffentlichungstag und Bekanntmachung des Hinweises auf die Patenterteilung: **14.04.1999**
(21) Anmeldenummer: 95100538.8
(22) Anmeldetag: 17.01.1995
(51) Int. Cl.: F02M 61/18, F02M 61/16, B05B 1/06, B05B 1/26, C25D 1/10

(54) **Verfahren zur Herstellung einer Düsenplatte**
Method of manufacturing a nozzle plate
Procédé de fabrication d'une plaque à buses

(30) Priorität: 09.02.1994 DE 4404021
(43) Veröffentlichungstag der Anmeldung: 16.08.1995
(73) Patentinhaber: ROBERT BOSCH GMBH, 70442 Stuttgart (DE)
(72) Erfinder: Treutler, Christoph, D-72827 Wannweil (DE); Benz, Gerhard, D-71032 Böblingen (DE); Kober, Hans-Friedemann, D-72072 Tübingen (DE)

(56) Entgegenhaltungen:
- EP-A- 0 354 660
- DE-A- 3 023 757
- DE-C- 921 837
- GB-A- 665 500
- US-A- 4 693 791
- US-A- 5 055 163

## Beschreibung

Die Erfindung betrifft ein Verfahren zur Herstellung einer Düsenplatte nach dem Oberbegriff des Anspruchs 1.

### Stand der Technik

Es ist ist bekannt, bei Brennkraftmaschinen von Kraftfahrzeugen Einspritzventile einzusetzen, über die der Kraftstoff in die Zylinderkammern Brennkraftmaschine gespritzt wird. Zur besseren Zerstäubung des Kraftstoffes ist bekannt, den Einspritzventilen Düsenplatten zuzuordnen, die zwischen den Einspritzventilen und den Zylinderkammern angeordnet sind. Diese Düsenplatten besitzen auf seiten der Einspritzventile Zuführungsöffnungen und auf seiten der Zylinderkammern Austrittsöffnungen. Zur besseren Zerstäubung des Kraftstoffes besitzen die Düsenplatten in der Regel eine Vielzahl von Zuführungs- und Austrittsöffnungen. Es ist auch bekannt, die Austrittsöffnung als Ringspalt auszubilden, um so eine bessere Zerstäubung des Kraftstoffes zu erreichen. Bei den bekannten Ringspaltdüsen ist jedoch nachteilig, daß die Ringspalte Stege enthalten, die störend auf eine gleichmäßige Zerstäubung des austretenden Kraftstoffes wirken.

Auch aus anderen Bereichen sind Einspritzdüsen und Verfahren zur Herstellung derselben bekannt. Beispielsweise offenbart die US 4,693,791 eine Methode zur Herstellung von Spinndüsen. Eine Spinndüse ist eine kleine Öffnung, durch welche organisches Material gepreßt wird, um eine Faser herzustellen (zu spinnen). Hierbei wird eine Gießform mit einer Elektrodenplatte kombiniert. Die Gießform - gegebenenfalls auch die Elektrode- weist Öffnungen auf, welche an derselben Stelle und von derselben Form sind wie die vorgesehenen Düsen. Die Öffnungen werden unter Vakuum mit einer aushärtbaren Gußmasse gefüllt. Nach dem Aushärten der Gußmasse wird die Gießform entfernt. Die Elektrodenplatte und die ausgehärtete Gußmasse bilden zusammen eine Negativform. Die Negativform wird in einem Galvanikbad mit einem Metall gefüllt. Anschließend wird die ausgehärtete Gußmasse der Negativform entfernt. Es bleibt eine Düsenplatte zurück, welche aus einem Abbild der ursprünglichen Gußform steht, wobei es möglich ist, daß die Elektrode Bestandteil bleibt.

Das Verfahren ist jedoch nicht einfach auf Benzineinspritzdüsen übertragbar, da es nicht geeignet ist, ununterbrochen-ringförmige Öffnungen herzustellen, und eine Zuführung zu der Offnung zu gestatten, die den Kraftstoff beispielsweise auf einem Kegelmantel führt, wodurch eine besonders gute Zerstäubung des Kraftstoffs gewährleistet wird.

### Vorteile der Erfindung

Das erfindungsgemäße Verfahren gemäß mit den im Anspruch 1 genannten Merkmalen hat den Vorteil, daß eine einen ununterbrochenen Ringspalt aufweisende Düsenplatte kostengünstig und mit hoher Präzision des Ringspaltes hergestellt werden kann. Dadurch, daß die Düsenplatte aus zwei mikromechanisch hergestellten Teilen, die durch Prägen oder Spritzgießen einer Kunststofform mit nachfolgender galvanischer Abformung hergestellt werden und die beiden Teile anschließend gefügt werden, kann mit einem einfachen Fertigungsablauf eine hochpräzise Düsenplatte hergestellt werden. Insbesondere lassen sich durch die mikromechanische Präzision Toleranzen einhalten, die trotz einer massenhaften Fertigung keine Qualitätseinbußen aufkommen lassen.

Weitere vorteilhafte Ausgestaltungen der Erfindung ergeben sich aus den übrigen in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figur 1: einen Längsschnitt durch eine Bekannte Düsenplatte;
- Figur 2: eine Draufsicht auf eine Düsenplatte gemäß Figur 1;
- Figur 3: eine Unteransicht einer Düsenplatte gemäß Figur 1;
- Figuren 4 bis 6: Verfahrensschritte zur Herstellung eines ersten Teils der Düsenplatte gemäß Figur 1;
- Figuren 7 bis 11: Verfahrensschritte zur Herstellung eines zweiten Teils der Düsenplatte gemäß Figur 1;
- Figuren 12 und 13: Verfahrensschritte zur Herstellung der Düsenplatte gemäß Figur 1;
- Figur 14: ein Herstellungsverfahren einer Düsenplatte in einer weiteren Ausführung;
- Figur 15: ein Herstellungsverfahren einer Düsenplatte in einer weiteren Ausführung;
- Figuren 16 bis 23: Verfahrensschritte zur Herstellung eines Stempels für die Herstellung eines ersten Teils der Düsenplatte gemäß Figur 1 und
- Figuren 24 bis 26: Verfahrenschritte zur Herstellung eines Stempels zum Herstellen eines zweiten Teils der Düsenplatte gemäß Figur 1.

### Beschreibung der Ausführungsbeispiele

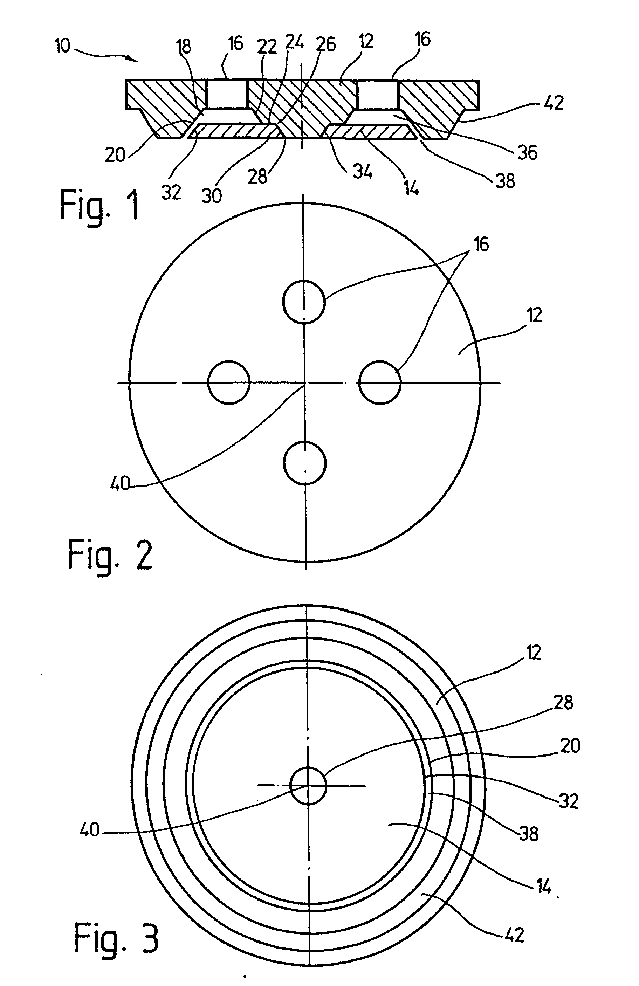

Figur 1 zeigt eine allgemein mit 10 bezeichnete Düsenplatte. Die Düsenplatte 10 besteht aus einem ersten Teil 12 und einem zweiten Teil 14. Das Teil 12 ist im gezeigten Beispiel rotationssymmetrisch, kann jedoch auch eine davon abweichende Form aufweisen. Das Teil 12 ist plattenförmig ausgebildet und besitzt Zuführungsöffnungen 16, die in einer an der Unterseite des Teils 12 angeordneten ringförmigen Ausnehmung 18 münden. Die Ausnehmung 18 besitzt eine äußere kegelstumpfförmig verlaufende Mantelfläche 20 und eine innere kegelstumpfförmig verlaufende Mantelfläche 22. Die Mantelfläche 22 besitzt einen Einschnitt 24, dessen Mantelfläche 26 ebenfalls kegelstumpfförmig verläuft. Das zweite Teil 14 ist scheibenförmig ausgebildet und besitzt eine zentrale Durchgangsöffnung 28. Eine Mantelfläche 30 der Durchgangsöffnung 28 und eine äußere Mantelfläche 32 des Teiles 14 verlaufen ebenfalls kegelstumpfförmig. Die Mantelfläche 26 des ersten Teiles 12 und die Mantelfläche 30 des zweiten Teiles 14 bilden einen Kegelsitz 34. Durch den Kegelsitz 34 findet eine selbstzentrierende Positionierung des ersten Teiles 12 in dem zweiten Teil 14 statt. Durch das Teil 14 wird in der Ausnehmung 18 ein Ringraum 36 gebildet, der über einen Ringspalt 38 zur Unterseite der Düsenplatte 10 mündet. Der Ringspalt 38 wird durch die jeweils kegelstumpfförmig verlaufenden Mantelflächen 20 des ersten Teiles 12 und 32 des zweiten Teiles 14 gebildet. Der Ringspalt 38 verläuft somit ebenfalls kegelstumpfförmig.

In der in Figur 2 gezeigten Draufsicht wird deutlich, daß die in dem ersten Teil 12 angeordneten Zuführungsöffnungen 16 im wesentlichen auf einer um einen Mittelpunkt 40 verlaufenden Kreisbahn angeordnet sind. Im gezeigten Beispiel sind vier Zuführungsöffnungen 16 vorgesehen, es können jedoch auch sechs, acht oder mehr Zuführungsöffnungen angeordnet sein. In der in Figur 3 gezeigten Unteransicht wird deutlich, daß der von den Teilen 12 und 14 gebildete Ringspalt 38 ununterbrochen um den Mittelpunkt 40 verläuft. Zur Anpassung an vorhandene Saugrohrgeometrien von Ottomotoren kann der Ringspalt auch zum Beispiel elliptisch geformt sein. Die entsprechenden Flächen wären dann elliptisch verzerrte Kegelmantelflächen. Alle beschriebenen Herstellschritte erlauben auch diese Geometrie. Das erste Teil 12 besitzt an seinem äußeren Rand noch einen ebenfalls kegelstumpfförmig verlaufenden Einschnitt 42, der jedoch lediglich zu Montagezwecken der Düsenplatte 10 dient und hier nicht weiter zu betrachten ist.

Die in den Figuren 1 bis 3 gezeigte Düsenplatte übt folgende Funktion aus.

Die Düsenplatte 10 wird derart vor ein nicht dargestelltes Einspritzventil gesetzt, daß das Teil 12 dem Einspritzventil zugewandt ist. An der Seite, an der das Teil 14 angeordnet ist, ist das Saugrohr einer ebenfalls nicht dargestellten Brennkraftmaschine angeordnet. In dem Moment, wo das Einspritzventil öffnet, strömt der Kraftstoff durch die Zuführungsöffnungen 16 in den druckverteilenden Ringraum 36 und von dort über den Ringspalt 38 in das Saugrohr der Brennkraftmaschine. Durch die kegelstumpfförmige Ausbildung des Ringspaltes 38 bildet der Kraftstoffstrahl eine zusammenhängende, ringförmige Strahllamelle, die sich auf dem von dem Ringspalt 38 vorgegebenen Kegelmantel (gegebenenfalls elliptisch verzerrt) ausbreitet. Mit zunehmendem Durchmesser der Strahllamelle in den Zylinderkammern der Brennkraftmaschine wird der Kraftstoffilm dünner, so daß er in sehr feine Tröpfchen zerfällt. Hierdurch wird eine sehr gleichmäßige Verteilung des Kraftstoffs auf ein relativ großes Volumen innerhalb der Zylinderkammern erreicht.

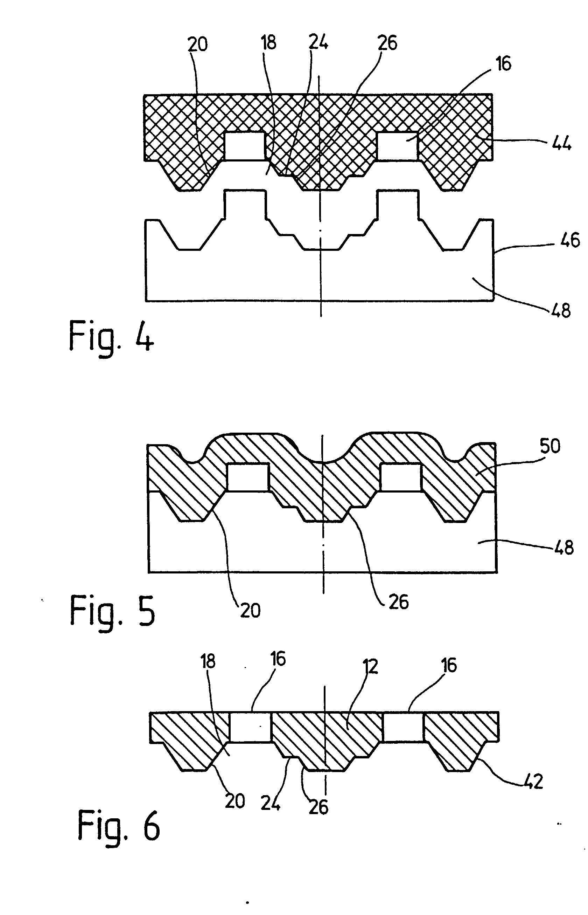

Anhand der Figuren 4 bis 6 wird das Herstellungsverfahren des in den Figuren 1 bis 3 gezeigten Teiles 12 verdeutlicht. In einem ersten Verfahrensschritt wird ein Prägestempel 44, der die Topographie des späteren Teiles 12 aufweist, in eine thermoplastisch verformbare Kunststoffmasse 46 gedrückt. Als Kunststoffmasse 46 kann beispielsweise Polymethylmethacrylat verwendet werden. Der Prägestempel 44 wird unter Wärmeeinwirkung in die Kunststoffmasse 46 gedrückt und erzeugt somit eine Negativform 48. Der Prägestempel 44 ist dabei identisch zu dem späteren Teil 12 aufgebaut und besitzt die eingearbeiteten Zuführungsöffnungen 16, die Ausnehmung 18, die Mantelfläche 20, den Einschnitt 24 sowie die Mantelfläche 26. In dem Beispiel ist der Prägestempel 44 anhand eines Teiles 12 gezeigt. Der Prägestempel 44 kann jedoch auch so ausgebildet sein, daß gleichzeitig eine Vielzahl von Negativformen 48 des Teiles 12 hergestellt werden, indem diese beispielsweise rastermäßig auf einer entsprechend groß ausgebildeten Kunststoffmasse 46 ausgeformt werden. Hierdurch wird durch einen einzigen Arbeitsgang, nämlich das Prägen mit dem Prägestempel 44, gleichzeitig eine Vielzahl von Negativformen 48 hergestellt. Anstelle der Herstellung der Negativform 48 durch Prägen kann diese alternativ auch durch Spritzgießen, Reaktionsguß oder ein anderes geeignetes Herstellungsverfahren hergestellt werden. Die die Negativform 48 ergebende Kunststoffmasse 46 ist dabei elektrisch leitfähig. Dies wird erreicht, indem der Kunststoffmasse 46 beispielsweise ein leitfähiger Füllstoff, zum Beispiel Metall oder Kohlenstoff, zugegeben wird oder die Negativform 48 an ihrer Oberfläche metallisiert wird. Die Metallisierung kann beispielsweise durch Sputtern oder Aufdampfen einer dünnen Metallschicht erfolgen. In einem nächsten, in Figur 5 verdeutlichten Verfahrensschritt wird auf die Negativform 48 in einem galvanischen Bad eine Schicht 50 aufgebracht. Die Schicht 50 besteht dabei beispielsweise aus Kupfer, Nickel oder Nickellegierungen. Durch die galvanische Abscheidung der Schicht 50, hierzu ist die Leitfähigkeit der Kunststoffmasse 46 notwendig, wird durch das Dickenwachstum der Schicht 50 ein Oberflächenrelief erzeugt, das die Konturen der Negativform 48 nachzeichnet. Die Schichtdicke der Schicht 50 beträgt dabei beispielsweise mehr als 200 µm. Die Schicht 50 legt sich durch das Galvanisieren eng an die Negativform 48 an, so daß die vorgegebenen Konturen, insbesondere die Mantelflächen 20 und 26, formtreu reproduziert werden. In einem nächsten Verfahrensschritt kann die Schicht 50 planarisiert werden, das heißt durch eine entsprechende Bearbeitung, beispielsweise Fräsen oder Schleifen, soweit abgetragen werden, daß die die Zuführungsöffnungen 16 ergebenden Bereiche der Negativform 48 freiliegen. Durch anschließendes Entformen der Schicht 50 von der Negativform 48 erhält man das in Figur 6 dargestellte Teil 12. Das Entformen kann beispielsweise durch Auflösen der Kunststoffmasse 46 erfolgen. Da die Kunststoffmasse 46 beispielsweise thermoplastisch ist, kann dies durch einfache Wärmezuführung, oder alternativ durch Lösungsmittel, erfolgen. Bei dem in Figur 6 gezeigten Teil 12 sind gleiche Abschnitte wie in Figur 1 mit gleichen Bezugszeichen versehen und hier nicht nochmals erläutert. Da - wie bereits erwähnt - gleichzeitig eine Vielzahl von Negativformen 48 geprägt werden, kann durch die Galvanisierung der Schicht 50 und der anschließenden Entformung ebenfalls gleichzeitig eine Vielzahl von Teilen 12 hergestellt werden. Die Vereinzelung der einzelnen Teile 12 aus dem Gesamtverbund wird anhand später nachfolgender Figuren verdeutlicht.

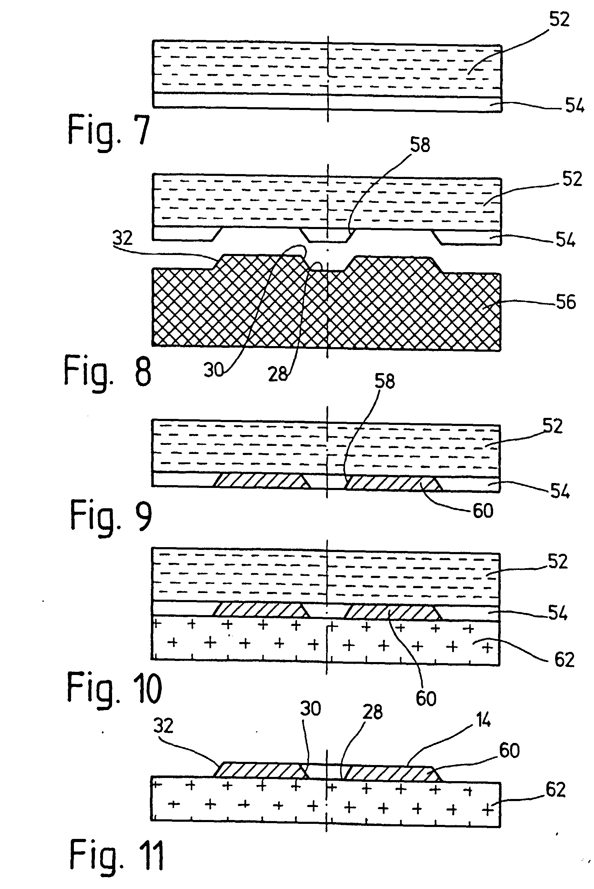

In den Figuren 7 bis 11 wird die Herstellung des in Figur 1 gezeigten Teiles 14 verdeutlicht. Figur 7 zeigt im Ausgangszustand einen Träger 52, der aus einem Metall oder einem leitfähigen Kunststoff besteht. Der Träger 52 ist mit einer Schicht 54 aus einer thermoplastisch verformbaren Kunststoffmasse, beispielsweise Polymethylmethacrylat, versehen. Wie in Figur 8 verdeutlicht, wird mittels eines Prägestempels 56, der an seiner Oberfläche die Kontur des späteren Teiles 14 aufweist, die Schicht 54 geprägt. Durch den Prägestempel 56 wird die Schicht 54 im Kontaktbereich mit dem Prägestempel 56 erwärmt, so daß die thermoplastische Kunststoffmasse dort schmilzt und somit eine Negativform 58 für das Teil 14 entsteht. Die Negativform 58 kann anstelle durch Heißprägen ebenfalls alternativ, beispielsweise durch Spritzguß, Reaktionsguß oder ein anderes geeignetes Verfahren hergestellt werden. In einem nächsten Verfahrensschritt wird, wie Figur 9 zeigt, die Negativform 58 in einem Galvanikbad mit beispielsweise Kupfer, Nickel oder einer Nickellegierung gefüllt. Hierbei wird ebenfalls, wie bereits bei der Herstellung des Teiles 12 erwähnt, durch isotropes Wachstum der galvanischen Schicht in der Negativform 58 eine später das Teil 14 ergebende Schicht 60 erzeugt. Die so erzeugte Schicht 60 weist eine formgetreue Nachbildung der für die spätere Düsenplatte 10 wichtigen Mantelflächen 32 bzw. 30 auf. Die Schicht 60 kann nunmehr durch ein nachfolgendes Fräsen oder Schleifen planarisiert werden, so daß eventuell während des Galvanisierens auftretende Unebenheiten beseitigt werden können. Dieses Planarisieren findet jedoch nur optional statt. In einem weiteren Verfahrensschritt wird, wie Figur 10 verdeutlicht, eine Trägerschicht 62 aufgebracht, so daß sich die Schicht 54 und 60 nunmehr zwischen dem Träger 52 und der Trägerschicht 62 befindet. Die Trägerschicht 62 wird so ausgewählt, daß sie den nachfolgenden noch zu beschreibenden Bearbeitungsschritten standhält. Die Trägerschicht 62 kann beispielsweise aus einer auflaminierten Kunststoffolie oder Klebefolie bestehen. Weiterhin ist der Einsatz eines mit Klebstoff versehenen metallischen Stempels möglich. Darüber hinaus kann die Trägerschicht 62 ebenfalls wie bereits die Schicht 60 aufgalvanisiert werden. So können vorzugsweise für den Fall, daß die Schicht 60 aus Nickel oder einer Nickellegierung besteht, die Prägestempel 62 aus einer galvanisch aufgetragenen Kupferschicht mit einer Stärke von beispielsweise 100 bis 200 µm bestehen. Nunmehr wird gemäß Figur 11 die Schicht 60 entformt, das heißt, der Träger 52 wird mit der daran befestigten Schicht 54 entfernt. Da die Schicht 54 aus einer thermoplastischen Kunststoffmasse besteht, kann diese durch Erwärmung, oder alternativ durch Lösungsmittel, beispielsweise aufgelöst werden. Gemäß der Figur 11 entsteht nunmehr eine Trägerschicht 62 mit einer Vielzahl, entsprechend der vorhandenen Anzahl der Negativformen 58 darauf befestigten Teilen 14.

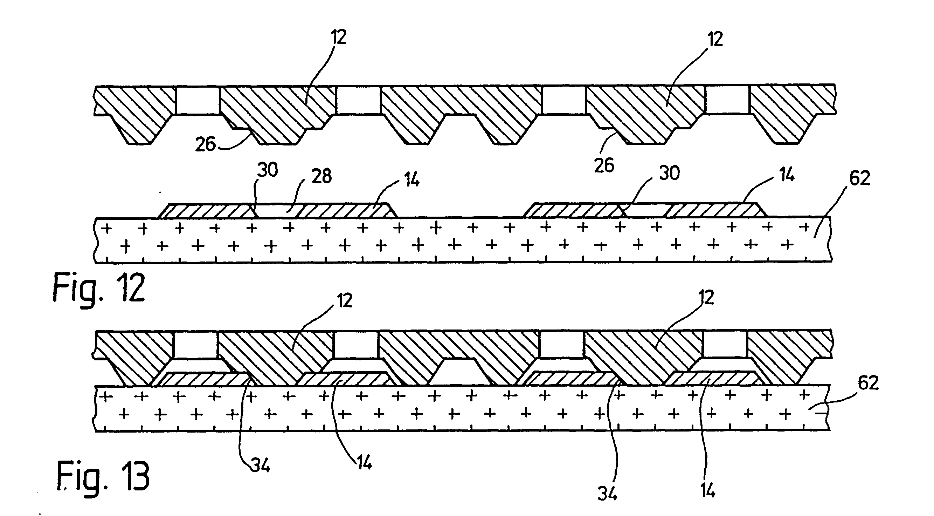

Anhand der Figuren 12 und 13 wird die Montage der Teile 12 und 14 näher erläutert. In der Figur 12 ist ein Ausschnitt aus einem Verbund von mehreren miteinander verbundenen Teilen 12 gezeigt. Diesem Verbund ist ein Ausschnitt aus einer Trägerschicht 62 mit mehreren darauf befestigten Teilen 14 zugeordnet. Die Zuordnung erfolgt dabei so, daß die Durchgangsöffnungen 28 der Teile 14 und damit die Mantelfläche 30 der Mantelfläche 26 der Teile 12 gegenüberliegt. Durch eine geeignete Fügevorrichtung werden die Verbunde nun zusammengeführt. Durch die kegelstumpfförmige Ausbildung der Mantelflächen 26 bzw. 30 ergibt sich eine Selbstjustierung des Kegelsitzes 34. Da die Trägerschicht 62 beispielsweise aus einer flexiblen Kunststoffolie besteht, können etwa bestehende Abweichungen bei der Zuordnung eines Teiles 14 zu einem Teil 12 problemlos ausgeglichen werden. Das Fügen der Teile 12 und 14 selbst kann beispielsweise durch Kleben, Diffusionslöten oder Diffusionsschweißen erfolgen. Hier kann beispielsweise eine dünne Klebstoffschicht, insbesondere im Bereich des Einschnitts 24 und der Mantelfläche 26 bzw. 30, durch Sprühen aufgebracht werden. Soll das Fügen durch Diffusionslöten erfolgen, kann ein metallisches Lot, zum Beispiel eine ca. 1 µm dicke Sn-Schicht durch Sputtern oder Aufdampfen aufgebracht werden. Damit lassen sich insbesondere durch eine sogenannte isotherme Erstarrung Nickel- oder Kupferbauteile sehr gut miteinander diffusionslöten. Selbst wenn zur Vereinfachung des Verfahrens die Kleberschicht oder der Lotauftrag nicht nur an den verbundenen Abschnitten in dem Bereich des Einschnitts 24 aufgetragen wird, ist durch die gewählte Formgebung der Teile 12 und 14 eine Verbindung an anderen Bereichen unmöglich.

In der Figur 13 ist ein gefügter Gesamtverbund aus einer Vielzahl von Teilen 12 mit einer Vielzahl von Teilen 14 gezeigt. Aus einem mit einem Teil 14 zusammengefügten Teil 12 ergibt sich die in Figur 1 gezeigte Düsenplatte 10. Nach dem Fügevorgang wird die Trägerschicht 62 entfernt. Ist die Trägerschicht 62 beispielsweise eine galvanisch aufgetragene Kupferschicht, kann diese naßchemisch selektiv gegenüber den beispielsweise auf Nickelbasis bestehenden Teilen 12 und 14 weggelöst werden. In einem weiteren Verfahrensschritt erfolgt das Vereinzeln des Fügeverbundes, so daß einzelne Düsenplatten 10 entstehen. Das Vereinzeln der Teile kann durch Trennschneiden, beispielsweise mit einem Laser, erfolgen. Als Laser kann hierbei ein Nd/YAG-Laser eingesetzt werden. Möglich ist jedoch auch Naßätzen durch eine Fotolackmaske. In dem Fall erfolgt ein Durchtrennen des Verbundes der Teile 12 in dem Bereich, der später den in Figur 1 erwähnten Einschnitt 42 ergibt. Da der Verbund gegenüber der Gesamtstärke hier besonders schmal ausgebildet ist, ist ein Vereinzeln problemlos möglich.

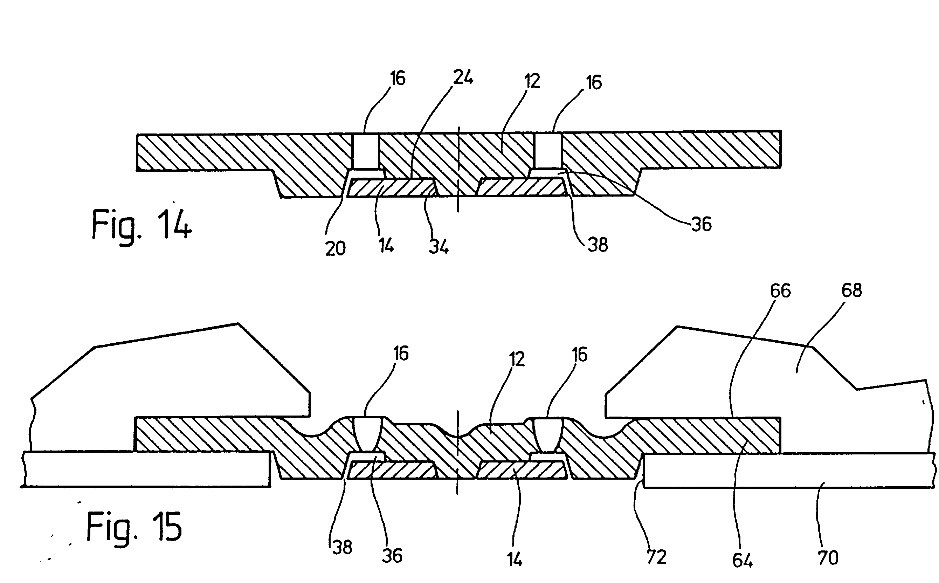

In den Figuren 14 und 15 sind Düsenplatten 10 gezeigt, die vom Prinzip her den gleichen Aufbau besitzen wie die in Figur 1 gezeigte Düsenplatte 10, bei denen jedoch zumindest teilweise andere Verfahrensschritte bei der Herstellung angewendet werden. Gleiche Teile wie in den bisherigen Figuren sind wiederum mit gleichen Bezugszeichen versehen. Bei der in Figur 14 gezeigten Düsenplatte 10 erfolgte das Fügen des Teils 14 mit dem Teil 12 durch Laserschweißen. Die Teile 12 und 14 werden dabei durch nicht dargestellte Hilfsplatten zusammengepreßt, die entsprechende Aussparungen besitzen, so daß der Laserstrahl Zutritt zu dem Fügebereich im Bereich des Einschnitts 24 hat. Miteinander verschweißt werden Teile der Kegelflächen 30 und 26 im Bereich des Kegelsitzes 34. Als Laser kann wiederum beispielsweise ein Nd/YAG-Laser eingesetzt werden.

In der Figur 15 ist die beispielsweise Anordnung einer Düsenplatte 10 vor einem Einspritzventil gezeigt. Ein Randbereich 64 des Teils 12 liegt dabei in einer entsprechenden Ausnehmung 66 eines Ventilsitzes 68. Gegen den Randbereich 64 ist dabei eine Scheibe 70 geführt, die diese Platte 10 in dem Ventilsitz 68 festklemmt. Die Scheibe 70 besitzt dabei eine Bohrung 72, so daß ein ungehinderter Kraftstoffdurchtritt durch die Düsenplatte 10 gewährleistet ist. Bei dem in Figur 15 gezeigten Ausführungsbeispiel sind die Zuführungsöffnungen 16 in dem Teil 12 durch eine entsprechende Fotolackmaske naßgeätzt. Hierbei bietet sich an, das Naßätzen der Zuführungsöffnungen 16 gleichzeitig mit dem Vereinzeln der Düsenplatten 10 aus dem in der Figur 13 gezeigten Verbund durchzuführen. Durch dieses gleichzeitige Einbringen der Zuführungsöffnungen 16 läßt sich die Form des Prägestempels 44 vereinfachen, da dieser den die Zuführungsöffnungen 16 ergebenden Bereich nicht mehr aufweisen muß. Hierdurch wird weiterhin erreicht, daß die in Figur 5 gezeigte Schicht 50 insgesamt flacher gehalten werden kann. Eine nachfolgende Planarisierung, beispielsweise durch Fräsen oder Schleifen, kann in diesem Fall entfallen, so daß der gesamte Herstellungsablauf vereinfacht wird.

Die fertigmontierten Düsenplatten 10 weisen typischerweise eine Spaltbreite der Düsenplatte 38 von 25 µm auf. Aufgrund der Selbstjustierung der Teile 12 und 14 zueinander innerhalb enger Toleranzbereiche kann durch die gewählte Abformtechnik mittels der Prägestempel 44 bzw. 56 und den anschließenden galvanischen Aufbau der Teile 12 und 14 eine derartige Genauigkeit erreicht werden, daß die Spaltweite des Ringspaltes 38 selbst für Werte von ca. 20 um zuverlässig eingehalten werden kann. Zum Einhalten derartiger genauer Maßtoleranzen, beispielsweise in Bereichen von ≤ 1 µm kommt den Prägestempeln 44 bzw. 56 eine besondere Bedeutung zu. Nachfolgend sollen die Verfahren zur Herstellung der Prägestempel 44 bzw. 56 näher erläutert werden.

Nach einem ersten Herstellungsverfahren können die Prägestempel 44 und 56 durch eine mechanische Mikrobearbeitung hergestellt werden. Da diese Prägestempel im wesentlichen rotationssymmetrisch ausgebildet sind, kann durch Mikrodrehen mit Präzisionsdiamanten als Werkzeug gearbeitet werden. Die spezielle Form der Prägestempel 44 und 56 ermöglicht einen ungehinderten Zugang des abtragenden Diamanten zu den Konturen der Prägestempel, ohne daß Hinterschneidungen angefertigt werden müssen. Diese mechanische Präzisionsbearbeitung ist insbesondere für die später die kegelstumpfförmigen Mantelflächen ergebenden Bereiche der Prägestempel notwendig, da es hier auf eine sehr hohe Genauigkeit ankommt. Da die Zuführungsöffnungen 16 - wie bereits erwähnt - nicht unbedingt mitabgeformt werden müssen, kann auf eine entsprechende Ausgestaltung des Prägestempels 44 verzichtet werden. Die Zuführungsöffnungen 16 können entweder naßchemisch geätzt oder in bekannter feinmechanischer Art gebohrt werden.

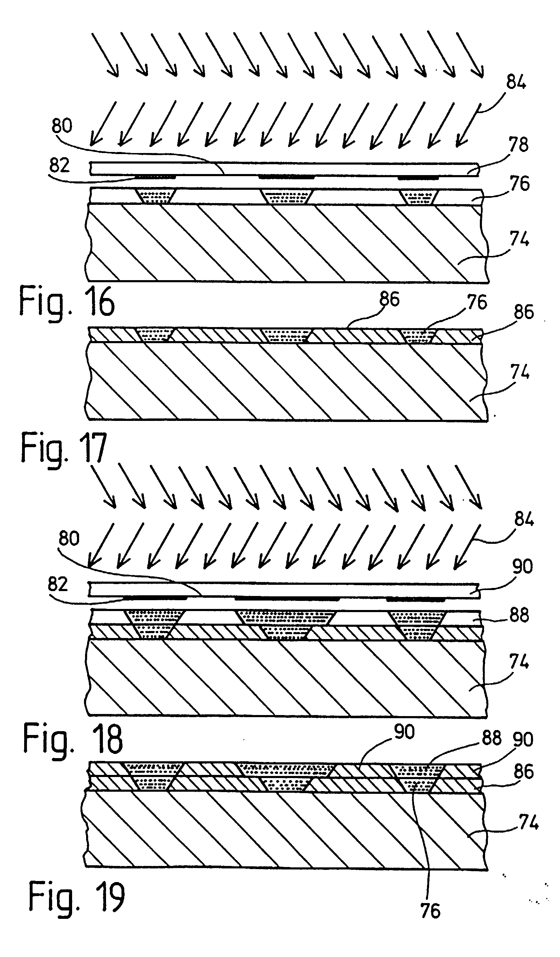

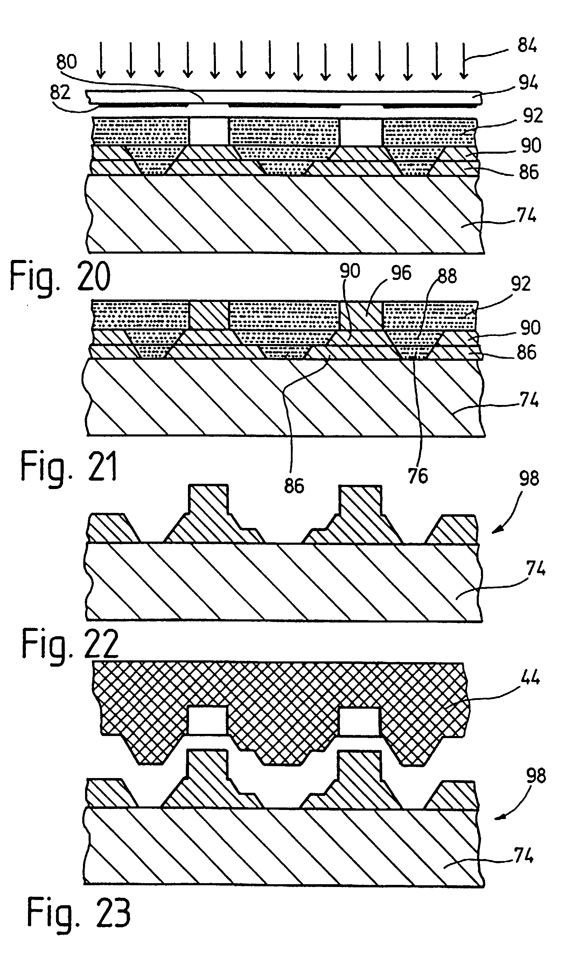

Anhand der Figuren 16 bis 23 wird ein zweites Herstellungsverfahren zur Herstellung des Prägestempels 44 erläutert. Als Ausgangsbasis für die Bearbeitung dient eine Trägerplatte 74, die mit einer Schicht 76 aus einem thermoplastisch verformbaren Kunststoff, beispielsweise Polymethylmethacrylat (PMMA) versehen ist. Über dem Schichtverbund aus der Trägerplatte 74 und der Schicht 76 wird eine Maske 78 angeordnet, die durchlässige Bereiche 80 und undurchlässige Bereiche 82 aufweist. Die Maske 78 und der Schichtverbund aus der Trägerplatte 74 und der Schicht 76 wird nun gemeinsam in Rotation versetzt und mit einer Synchrotronstrahlung 84 behandelt. Die Synchrotronstrahlung wird nach der allgemein bekannten LIGA-Technik erzeugt und verwendet, nach der ein Kunststoff mit der Synchrotronstrahlung behandelt werden kann, anschließend belichtet und entwickelt wird, so daß die nicht mit Synchrotronstrahlen behandelten Bereiche des Kunststoffs als Oberflächenstrukturen zur Verfügung stehen. Im gezeigten Beispiel (Figur 16) wird die Synchrotronstrahlung 84 jeweils unter einem bestimmten Winkel, der der späteren Neigung der kegelstumpfförmigen Mantelflächen 20 bzw. 26 des Teiles 12 entspricht, auf das rotierende System abgestrahlt. Hierdurch findet eine Hinterleuchtung der Maske 78 an den undurchlässigen Bereichen 82 statt, so daß in der Schicht 76 ein erstes Teil der späteren Ausnehmung 18 strukturiert werden kann. Die Schichtdicke der Schicht 76 entspricht dabei der späteren Dicke des Teiles 14. In einem nächsten Verfahrensschritt wird die metallische Trägerplatte 74 mit der strukturierten Schicht 76 galvanisiert, so daß in den geschaffenen Strukturen der Schicht 76 eine Galvanikschicht 86 isotrop aufwachsen kann. Im Anschluß erfolgt ein eventuelles Überschleifen der Galvanikschicht 86, so daß eine planarisierte Oberfläche entsteht. In einem nächsten Verfahrensschritt (Figur 18) wird auf die jetzt vorhandene Struktur eine neue Kunststoffschicht 88 mit wiederum gleichen Eigenschaften wie die Schicht 76 aufgebracht. Darüber wird eine zweite Maske 90 mit ebenfalls wieder durchlässigen Bereichen 80 und undurchlässigen Bereichen 82 angeordnet. Die Wahl der undurchlässigen Bereiche 82 richtet sich nach der zu schaffenden Struktur in der Schicht 88. Durch neuerliche Bestrahlung mit einer Synchrotronstrahlung 84 unter den entsprechenden Winkeln, wobei das darunter angeordnete System aus der Maske und dem Schichtenaufbau rotiert, wird in der Schicht 88 der später den Ringraum 36 ergebende Bereich der Ausnehmung 18 strukturiert. In den nunmehr geschaffenen Strukturen in der Schicht 88 wird ebenfalls wieder eine Galvanikschicht 90 aufgebaut. In einem nächsten Verfahrensschritt (Figur 20) wird eine dritte Schicht 92 aus Kunststoff aufgebracht, die mit einer dritten Maske 94 mit der Synchrotronstrahlung 84 in entsprechender Weise behandelt wird. In diesem Fall trifft die Synchrotronstrahlung 84 senkrecht auf die Maske 94, so daß die undurchlässigen Bereiche 82 nicht hinterleuchtet werden und somit in der Schicht 92 Bereiche mit senkrecht verlaufenden Wänden strukturiert werden. Die in der Schicht 92 strukturierten Bereiche ergeben die späteren Zuführungsöffnungen 16. In die aus der Schicht 92 herausbelichteten Bereiche wird in einem nächsten Verfahrensschritt ebenfalls eine Galvanikschicht 96 aufgebaut. Die einzelnen in den Kunststoffschichten 76, 88 und 92 eingebrachten Galvanikschichten 86, 90 und 96 bilden einen Verbund und sind unlösbar miteinander verbunden. Nunmehr wird der verbliebene Rest der Kunststoffschichten 76, 88 und 92 weggelöst, beispielsweise durch eine Wärmebehandlung oder durch Lösungsmittel, so daß sich eine Trägerplatte 74 mit den aufgebauten Galvanikschichten ergibt (Figur 22). Diese mit den Galvanikstrukturen versehene Trägerplatte 74 bildet ein Bauteil 98, das eine Negativform für den Prägestempel 44 darstellt. Die Negativform 98 wird nunmehr verwendet, um den Prägestempel 44 galvanisch abzuformen (Figur 23). Durch Einhaltung entsprechender Verfahrensparameter kann auch eine metallische Form, hier die Negativform 98, in Metall, hier der spätere Prägestempel 44, abgeformt werden. Hierzu ist die galvanische Badführung so einzustellen, daß eine geringe Haftung der aufgalvanisierten Metallschichten auf der metallischen Form erhalten wird. Gegebenenfalls ist zwischen der Negativform 98 und dem aufgalvanisierten Prägestempel 44 vorher eine Trennschicht einzubringen. Nach Beendigung der Aufgalvanisierung des Prägestempels 44 weist dieser die in Figur 4 gezeigte Form auf und ist für die Abformung der Teile 12 der Düsenplatte 10 geeeignet.

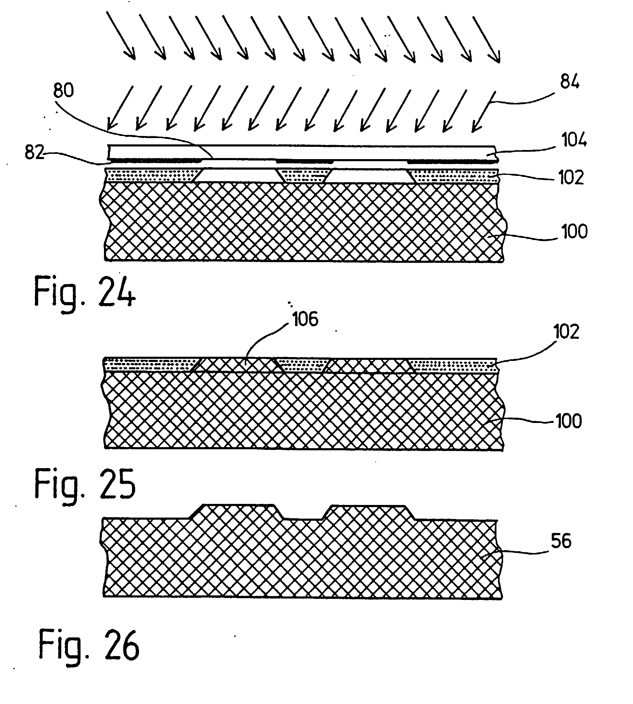

In den Figuren 24 bis 26 ist die Herstellung eines Prägestempels 56 zur Abformung der Teile 14 näher gezeigt. Das Herstellungsverfahren läuft analog den in den Figuren 16 bis 23 gezeigten Verfahren zur Herstellung des Prägestempels 44 ab. Eine metallische Trägerplatte 100 wird mit einer Schicht 102 aus thermoplastisch verformbarem Kunststoff, beispielsweise PMMA, versehen. Diese Schicht 102 wird über eine Maske 104 mit der Synchrotronstrahlung 84 belichtet. Die Synchrotronstrahlung 84 ist dabei wieder unter einem bestimmten wählbaren Winkel auf die Maske 104 gerichtet, und wiederum rotieren Maske und Trägerplatte gemeinsam, so daß die undurchlässigen Bereiche 82 hinterleuchtet werden können. Hierdurch ergibt sich in der Schicht 102 eine Strukturierung, die dem späteren Teil 14 entspricht. Der Winkel der Synchrotronstrahlung 84 wird wiederum so gewählt, daß sich die Winkel der kegelstumpfförmigen Mantelflächen 30 bzw. 32 des Teils 14 einstellen. In einem nächsten Verfahrensschritt wird in den in der Schicht 102 geschaffenen Strukturen eine Galvanikschicht 106 aufgebaut, die sich mit der Trägerplatte 100 verbindet. Nachdem die verbleibende Schicht 102 beispielsweise durch Wärmeeinwirkung oder Lösungsmitteleinsatz weggelöst wurde, verbleibt ein aus der Trägerplatte 100 und der Galvanikschicht 106 verbleibendes Teil, das den Prägestempel 56 bildet (Figur 26).

In den Figuren 16 bis 26 ist beispielhaft die Herstellung der Prägestempel 44 und 56 für die Ausprägung eines Teiles 12 bzw. 14 gezeigt. Mit dem dargestellten Verfahren gemäß der LIGA-Technik können jedoch gleichzeitig eine Vielzahl von Prägestempeln 44 bzw. 56 auf einer Trägerplatte 74 bzw. 100 erzeugt werden. Dies ist insbesondere dadurch möglich, da die Synchrotron-Strahlenquelle einen relativ großen Strahlenquerschnitt der Synchrotronstrahlung 84 aufweist, so daß gleichzeitig eine verhältnismäßig große Fläche bestrahlt werden kann.

Die Herstellung der Prägestempel 44 bzw. 56 beschränkt sich nicht auf das in den Figuren 16 bis 26 gezeigte Beispiel. So ist beispielsweise möglich, den Ringraum 36 der Düsenplatte 10 mit senkrecht verlaufenden Wänden so zu versehen, daß die diesen Bereich des Prägestempels 44 strukturierende Synchrotronstrahlung 84 ebenfalls senkrecht ausgerichtet sein kann. Hierdurch ergibt sich eine Vereinfachung des Prägestempels 44 und damit auch seines Herstellungsverfahrens. Weiterhin bietet sich die Möglichkeit, bei der Strukturierung der Zuführungsöffnungen 16 mittels der LIGA-Technik die Möglichkeit, diese als feine Kanäle oder siebartige Strukturen auszubilden. Diese feinen Kanäle oder siebartigen Strukturen können gleichzeitig einen Filter gegen Verschmutzungen im Kraftstoff bilden, so daß eine Verunreinigung bzw. Verstopfung des Ringspaltes 38 durch diese Verschmutzungen ausgeschlossen werden kann. Die Maschenweite der feinen Kanäle oder siebartigen Strukturen wird dann kleiner als die Spaltweite des Ringspaltes 38 gewählt. Gegebenenfalls kann bei der Herstellung der Prägestempel 44 bzw. 56 die LIGA-Technik mit der feinmechanischen Präzisionsbearbeitung kombiniert werden. Dabei werden dann nur die für die Ausbildung des Ringspaltes 38 wichtigen, die später die Mantelflächen 20, 26, 30 und 32 ergebenden Bereiche der Prägestempel 44 bzw. 56 mit Hilfe der LIGA-Technik strukturiert. Die weniger kritischen Strukturen, beispielsweise für den Ringraum 36 und/oder die Zuführungsöffnungen 16, können durch die feinmechanische Präzisionsbearbeitung erzeugt werden.

Durch die in den Ausführungsbeispielen beschriebenen Herstellungsverfahren ist es möglich, Düsenplatten 10 aus den zwei Teilen 12 und 14 mit einer geeigneten Fügetechnik herzustellen, die gegenüber einer aus einem Teil gefertigten Düsenplatte einen wesentlich einfacheren Fertigungsablauf beinhalten, der kostengünstiger und sicherer zu beherrschen ist. Durch den konsequenten Einsatz der Abformtechnik wird eine kostengünstige Massenfertigung selbst dann möglich, wenn die Prägestempel 44 und 56 durch die hochpräzise und damit relativ aufwendige LIGA-Technik hergestellt werden. Insbesondere kann die Formgebung der Teile 12 und 14 so gewählt werden, daß die für die Funktion wichtigen Innenflächen, das heißt die Mantelflächen 20, 26, 30 und 32, der Ringspalt 38, der Kegelsitz 34 mit mikromechanischer Präzision bei Toleranzen von ca. 1 µm abgeformt werden können. Die nur für die Montage wichtigen Außenflächen bzw. Zuführungsöffnungen 16 können mit einfacheren Bearbeitungsverfahren, wie beispielsweise Planfräsen oder Naßätzen, gefertigt werden. Durch eine spezielle Formgestaltung für die Teile 12 und 14 wird erreicht, daß jeweils die für die Zentrierung notwendigen kegelstumpfförmigen Mantelflächen 26 und 30 und die den Ringspalt 38 ergebenden kegelstumpfförmigen Mantelflächen 20 und 32 durch ein und dieselbe Maske 78 bzw. 104 festgelegt werden können. Durch diese hochpräzise Maskierung sind Toleranzen im Sub-µm-Bereich möglich und ein zusätzlicher Fehler durch ungenaue Justage zweier Masken zueinander wird vermieden. Hierdurch wird eine sehr hohe Reproduzierbarkeit für die Spaltweite der Ringspalte 38 ermöglicht. Durch die gefundenen Herstellungsverfahren sind Ringspalte 38 mit Spaltweiten herunter bis zu ca. 20 µm mit hoher Genauigkeit herstellbar. Durch die gleichzeitige Herstellung einer Vielzahl von Prägestempel 44 und 56 und der daraus resultierenden gleichzeitigen Abformung einer Vielzahl von Teilen 12 und 14 ist das Herstellungsverfahren mit hoher Effektivität durchführbar.

## Patentansprüche

1. Verfahren zur Herstellung einer metallischen Düsenplatte (10), insbesondere für Einspritzventile, wobei das Metall für die Düsenplatte galvanisch abgeschieden wird, dadurch gekennzeichnet, daß eine erste Teilplatte (12) durch Prägen oder Spritzgießen einer ersten Form (48), insbesondere einer Kunststofform, mit nachfolgender galvanischer Abformung hergestellt wird, daß eine zweite Teilplatte (14) durch Prägen oder Spritzgießen einer zweiten Form (58), insbesondere einer Kunststofform, mit nachfolgender galvanischer Abformung hergestellt wird und daß die erste Teilplatte (12) und die zweite Teilplatte (14) aufeinander zusammengefügt werden.

2. Verfahren nach Anspruch 1, dadurch gekennzeichnet, daß gleichzeitig eine Vielzahl von Formen (48, 58) geprägt werden.

3. Verfahren nach einem der Ansprüche 1 oder 2, dadurch gekennzeichnet, daß die Prägung der Formen (48,58) in eine elektrisch leitfähige Kunststoffmasse (46,54) erfolgt.

4. Verfahren nach Anspruch 3, dadurch gekennzeichnet, daß die Kunststoffmasse (46,54) mit einem leitfähigen Füllstoff und/oder einer Oberflächenmetallisierung versehen wird.

5. Verfahren nach einem der Ansprüche 1 bis 4, dadurch gekennzeichnet, daß zweite Teilplatten (14) in einem, dem Rastermaß einer Vielzahl von zusammenhängenden ersten Teilplatten (12) entsprechenden Rastermaß auf eine vorzugsweise flexible Trägerschicht (62) aufgebracht werden.

6. Verfahren nach einem der Ansprüche 1 bis 5, dadurch gekennzeichnet, daß die Teilplatten (12, 14) durch Kleben aufeinander zusammengefügt werden.

7. Verfahren nach einem der Ansprüche 1 bis 5, dadurch gekennzeichnet, daß die Teilplatten (12, 14) mittels Diffusionslöten oder Diffusionsschweißen zusammengefügt werden.

8. Verfahren nach einem der Ansprüche 1 bis 7, dadurch gekennzeichnet, daß eine Vereinzelung des Fügeverbundes aus einer Vielzahl von Teilplatten (12, 14) durch Laserschneiden oder Naßätzen erfolgt.

9. Verfahren nach Anspruch 8, dadurch gekennzeichnet, daß gleichzeitig mit dem Vereinzeln des Fügeverbundes die Zuführungsöffnungen (16) in die ersten Teilplatten (12) eingeätzt werden.

10. Verfahren nach einem der Ansprüche 1 bis 3, dadurch gekennzeichnet, daß ein zum Prägen benötigter Prägestempel (44, 56) durch eine mechanische Mikrobearbeitung hergestellt wird.

11. Verfahren nach einem der Ansprüche 1 bis 3, dadurch gekennzeichnet, daß ein zum Prägen benötigter Prägestempel (44) durch galvanische Abformung einer Negativform (98), die mittels Synchrotronstrahlung (84) in einem thermoplastisch verformbaren Kunststoff (76,88,92) strukturiert und die anschließend galvanisch abgeformt wird, hergestellt wird.

12. Verfahren nach Anspruch 11, dadurch gekennzeichnet, daß die Negativform (98) aus einzelne Schichten aufgebaut wird, die durch abwechselnde Synchrotronbestrahlung (84) und galvanische Abformung erzeugt werden.

## Claims

1. Process for producing a metallic nozzle plate (10), in particular for injection valves, the metal for the nozzle plate being electrodeposited, characterized in that a first sub-plate (12) is produced by the embossing or injection-moulding of a first mould (48), especially of a plastic mould, with subsequent electroforming, in that a second sub-plate (14) is produced by the embossing or injection-moulding of a second mould (58), especially of a plastic mould, with subsequent electroforming, and in that the first sub-plate (12) and the second sub-plate (14) are joined to one another.

2. Process according to Claim 1, characterized in that a multiplicity of moulds (48, 58) are embossed simultaneously.

3. Process according to one of Claims 1 or 2, characterized in that the embossing of the moulds (48, 58) takes place in an electrically conductive plastic mass (46, 54).

4. Process according to Claim 3, characterized in that the plastic mass (46, 54) is provided with a conductive filler and/or with a surface metallization.

5. Process according to one of Claims 1 to 4, characterized in that the second sub-plates (14) are applied to a preferably flexible carrier layer (62) in a grid spacing corresponding to the grid spacing of a multiplicity of interconnected first sub-plates (12).

6. Process according to one of Claims 1 to 5, characterized in that the sub-plates (12, 14) are joined to one another by bonding.

7. Process according to one of Claims 1 to 5, characterized in that the sub-plates (12, 14) are joined to one another by means of diffusion soldering or diffusion welding.

8. Process according to one of Claims 1 to 7, characterized in that a separation of the joined composite structure consisting of a multiplicity of sub-plates (12, 14) takes place by laser cutting or wet etching.

9. Process according to Claim 8, characterized in that the feed orifices (16) are etched into the first sub-plates (12) simultaneously with the separation of the joined composite structure.

10. Process according to one of Claims 1 to 3, characterized in that an embossing die (44, 56) required for embossing is produced by mechanical micromachining.

11. Process according to one of Claims 1 to 3, characterized in that an embossing die (44) required for embossing is produced by the electroforming of a negative mould (98) which is structured in a thermoplastically deformable plastic (76, 88, 92) by means of synchrotron radiation (84) and which is subsequently electroformed.

12. Process according to Claim 11, characterized in that the negative mould (98) is composed of individual layers which are produced by alternate synchrotron irradiation (84) and electroforming.

## Revendications

1. Procédé de fabrication d'une plaque à buses (10), métallique, notamment pour des injecteurs, selon lequel on dépose par voie galvanique le métal de la plaque à buses,
caractérisé en ce qu'
- on réalise une première plaque partielle (12) par matriçage ou injection d'un premier moule (48) notamment d'un moule en matière plastique puis on moule par voie galvanique,
- on réalise une plaque formant une seconde pièce (14) par matriçage ou injection d'un second moule (58), notamment d'un moule en matière plastique suivi d'un moulage galvanique et,
- on réunit la plaque de la première pièce (12) et la plaque de la seconde pièce (14).

2. Procédé selon la revendication 1,
caractérisé en ce qu'
on matrice en même temps un grand nombre de moules (48, 58).

3. Procédé selon l'une quelconque des revendications 1 ou 2,
caractérisé en ce que
le matriçage des moules (48, 58) se fait dans une masse de matière plastique (46, 54) conductrice électriquement.

4. Procédé selon la revendication 3,
caractérisé en ce qu'
on charge la masse de matière plastique (46, 54) d'une matière conductrice et/ou on métallise sa surface.

5. Procédé selon l'une quelconque des revendications 1 à 4,
caractérisé en ce qu'
on applique la plaque de la seconde pièce (14) selon une trame correspondant à celle d'un grand nombre de plaques formant les premières pièces (12), réunies, de préférence sur une couche de support (62) souple.

6. Procédé selon l'une quelconque des revendications 1 à 5,
caractérisé en ce qu'
on réunit les plaques des pièces (12, 14) par collage.

7. Procédé selon l'une quelconque des revendications 1 à 5,
caractérisé en ce qu'
on réunit les plaques des pièces (12, 14) par brasage à diffusion ou soudage à diffusion.

8. Procédé selon l'une quelconque des revendications 1 à 7,
caractérisé en ce qu'
on sépare l'ensemble formé d'un grand nombre de plaques de pièces (12, 14) par découpe au laser ou attaque chimique par voie humide.

9. Procédé selon la revendication 8,
caractérisé en ce qu'
en même temps que l'on sépare l'ensemble des pièces, on réalise par attaque chimique les orifices d'entrée (16) dans les plaques des premières pièces (12).

10. Procédé selon l'une quelconque des revendications 1 à 3,
caractérisé en ce qu'
on réalise le poinçon (44, 56) nécessaire au matriçage par un micro-usinage mécanique.

11. Procédé selon l'une quelconque des revendications 1 à 3,
caractérisé en ce qu'
on réalise un poinçon de matriçage (44) nécessaire au matriçage par moulage galvanique d'un moule négatif (98) lui-même obtenu en structure ou par rayonnement de synchrotron (84) et une matière thermoplastique (76, 88, 92) puis en la moulant par voie galvanique.

12. Procédé selon la revendication 11,
caractérisé en ce qu'
on réalise le moule négatif (98) à partir de couches formées séparément qui sont obtenues par irradiation de synchrotron (84) alternant avec un moulage galvanique.
